# EUROPEAN PATENT APPLICATION

(11) **EP 4 764 555 A1**
(43) Date of publication of application: **24.06.2026**
(21) Application number: 25864144.8
(22) Date of filing: 05.09.2025
(51) Int. Cl.: G01R 31/392, G01R 31/396, G01R 31/382, G01R 31/36, G01R 31/367

(54) **BATTERY DIAGNOSTIC DEVICE AND METHOD THEREOF**

(30) Priority: 05.09.2024 KR 20240120896
(71) Applicant: LG Energy Solution, Ltd., Seoul 07335 (KR)
(72) Inventor: CHOI, Jeong Hyeon, Daejeon 34122 (KR); JEONG, Yu Na, Daejeon 34122 (KR); JO, Hyuk Jun, Daejeon 34122 (KR); KANG, Seo Hee, Daejeon 34122 (KR)
(74) Representative: Plasseraud IP
(86) International application number: PCT/KR2025/013794
(87) International publication number: WO 2026/054581

(57) **Abstract**

A battery diagnosis device according to an embodiment of this document include an interface configured to acquire a first profile related to a state of charge (SOC) of a battery and a processor, in which the processor is configured to acquire a second profile obtained by correcting the first profile based on applying a designated algorithm to the first profile, identify, based on identifying at least one first feature point in the second profile, at least one second feature point in the first profile using the at least one first feature point, and acquire an operating pattern of the battery based on the at least one second feature point.

## Description

### TECHNICAL FIELD

### CROSS-REFERENCE TO RELATED APPLICATIONS

This application claims priority from Korean Patent Application No. 10-2024-0120896, filed on September 5, 2024, the disclosure of which is incorporated by reference herein.

### TECHNICAL FIELD

Embodiments disclosed in this document relate to a battery diagnosis device and battery diagnosis method.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, secondary batteries have been receiving attention as a next-generation energy storage medium, as their scope of use has expanded to include power sources for electric vehicles.

The performance of a battery degrades over time, which may be attributed to chemical and physical changes in the battery. Therefore, technology that accurately predicts the life of the battery can be crucial for ensuring battery reliability and stability of the battery, determining appropriate replacement timing, and reducing maintenance costs. Therefore, the importance of technology for accurately predicting the life of a battery is increasing in various industrial fields, and continuous research and development may be required.

### DISCLOSURE OF THE INVENTION

### TECHNICAL PROBLEM

Embodiments provide a battery diagnosis device and battery diagnosis method for accurately predicting the life of a battery by acquiring an operating pattern of the battery and predicting the life of the battery.

Embodiments provide a battery diagnosis device and battery diagnosis method for accurately predicting the life of the battery without actually charging and discharging the battery.

Embodiments provide a battery diagnosis device and battery diagnosis method for accurately predicting the life of a battery even when the battery is operated in multiple operating modes by predicting the life of the battery using the operating pattern of the battery.

The technical problems of the present invention are not limited to the technical problems mentioned above, and other technical problems that are not mentioned may be clearly understood by those skilled in the art from the descriptions below.

### TECHNICAL SOLUTION

A battery diagnosis device according to an embodiment of this document includes an interface configured to acquire a first profile related to a state of charge (SOC) of a battery, and a processor, in which the processor is configured to acquire a second profile obtained by correcting the first profile based on applying a designated algorithm to the first profile, identify, based on identifying at least one first feature point in the second profile, at least one second feature point in the first profile using the at least one first feature point, and acquire an operating pattern of the battery based on the at least one second feature point.

In an embodiment, the processor may be configured to predict the life of the battery based on the operating pattern of the battery.

In an embodiment, the processor may be configured to identify the at least one second feature point that exists between a plurality of feature points including the at least one first feature point.

In an embodiment, the processor may be configured to acquire the first profile related to the SOC of the battery identified for a designated duration.

In an embodiment, the designated algorithm may include a local regression analysis algorithm.

In an embodiment, the local regression analysis algorithm may include locally estimated scatterplot smoothing (LOESS).

In an embodiment, the at least one first feature point may include an extremum point, and the at least one second feature point may include a local extremum point.

In an embodiment, the operating pattern may include at least one of a cycle mode, a FR mode, or any combination thereof.

A battery diagnosis method according to an embodiment of this document include an operation of acquiring, by a processor, based on applying a designated algorithm to a first profile related to a state of charge (SOC) of a battery, a second profile obtained by correcting the first profile, an operation of identifying, by the processor, based on identifying at least one first feature point in the second profile, at least one second feature point in the first profile using the at least one first feature point, and an operation of acquiring, by the processor, an operating pattern of the battery based on the at least one second feature point.

The battery diagnosis method according to an embodiment may include an operation of predicting the life of the battery based on the operating pattern of the battery.

The battery diagnosis method according to an embodiment may include an operation of identifying the at least one second feature point that exists between a plurality of feature points including the at least one first feature point.

The battery diagnosis method according to an embodiment may include an operation of acquiring the first profile related to the SOC of the battery identified for a designated duration.

In an embodiment, the designated algorithm may include a local regression analysis algorithm.

In an embodiment, the local regression analysis algorithm may include locally estimated scatterplot smoothing (LOESS).

In an embodiment, the at least one first feature point may include an extremum point, and the at least one second feature point may include a local extremum point.

### ADVANTAGEOUS EFFECTS

The present technology can accurately predict the life of a battery by acquiring the operating pattern of the battery and predicting the life of the battery.

In addition, the present technology can accurately predict the life of the battery without actually charging and discharging the battery.

In addition, the present technology can accurately predict the life of the battery even when the battery is operated in multiple operating modes by predicting the life of the battery using the operating pattern of the battery.

In addition, various effects that are directly or indirectly identified through this document can be provided.

### BRIEF DESCRIPTION OF THE DRAWINGS

FIG. 1 is a block diagram illustrating a battery pack, in a battery diagnosis device and battery diagnosis method according to an embodiment of this document.
FIG. 2 illustrates an example of a block diagram illustrating a configuration of a battery diagnosis device according to an embodiment of this document.
FIGS. 3a to 3e illustrate examples related to a first profile and/or a second profile in an embodiment of this document.
FIG. 4 illustrates an example of a flowchart related to a battery diagnosis method according to an embodiment of this document.
FIG. 5 illustrates an example of predicting the life of a battery using a battery diagnosis device and/or a battery diagnosis method according to an embodiment of this document.
FIG. 6 is a block diagram illustrating a hardware configuration of a computing system that performs a battery diagnosis method, in a battery diagnosis device and battery diagnosis method according to an embodiment of this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to an embodiment, the method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

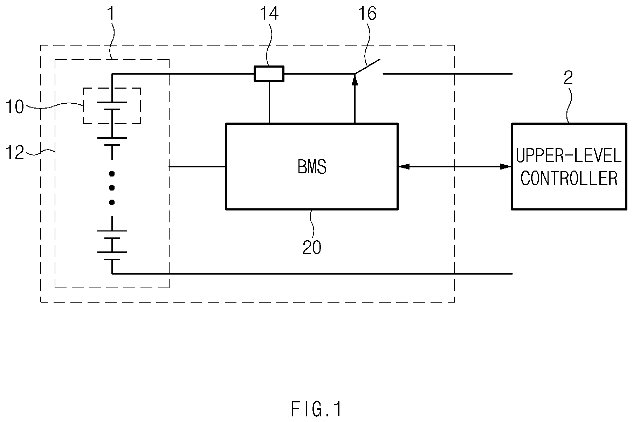

Hereinafter, embodiments of this document will be described in detail with reference to FIGS. 1 to 6.

FIG. 1 is a block diagram showing a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 12 may include at least one battery cell 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharging and overdischarging, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

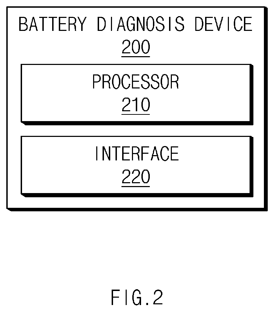

According to an embodiment, the battery management system 20 may include a battery diagnosis device 200 of FIG. 2. According to another embodiment, the battery management system 20 may be a different system from the battery diagnosis device 200 of FIG. 2. That is, the battery diagnosis device 200 of FIG. 2 may be included in the battery pack 1 or may be configured as another device external to the battery pack 1. Hereinafter, for convenience of description, the description will be made on the assumption that the battery diagnosis device 200 is configured as another device external to the battery pack 1. In addition, the operation of the battery diagnosis device 200 described below may be performed by a BMS in the vehicle, and may also be performed by various devices such as a server, a cloud, a charger, or a discharger.

FIG. 2 illustrates an example of a block diagram illustrating the configuration of a battery diagnosis device according to an embodiment of this document.

Referring to FIG. 2, the battery diagnosis device 200 according to an embodiment may include a processor 210 and a memory 220. The processor 210 and the memory 220 may be electrically and/or operably coupled with each other by an electronic component including a communication bus.

Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware.

Although pieces of hardware are illustrated in different blocks, embodiments are not limited thereto. For example, some of the pieces of hardware of FIG. 2 may be included in a single integrated circuit including a system on a chip (SoC). The type and/or number of pieces of hardware included in the battery diagnosis device 200 is not limited to that shown in FIG. 2. For example, the battery diagnosis device 200 may include only some pieces of the hardware shown in FIG. 2.

The battery diagnosis device 200 according to an embodiment may include hardware for processing data based on one or more instructions. The hardware for processing data may include the processor 210.

For example, hardware for processing data may include an arithmetic and logic unit (ALU), a floating point unit (FPU), a field programmable gate array (FPGA), a central processing unit (CPU), and/or an application processor (AP). The processor 210 may have a single-core processor architecture or a multi-core processor architecture having dual cores, quad cores, hexa cores, or octa cores.

An interface 220 of the battery diagnosis device 200 according to an embodiment may be configured to generate battery measurement values from the battery (e.g., one or more battery cells 11 of FIG. 1). To this end, the interface 220 may include a measuring means such as a voltmeter, an ammeter, a thermometer, etc., and/or a communication module for establishing a connection with an external device.

For example, the interface 220 may include at least one of a hardware interface, a software interface, or any combination thereof.

For example, the interface 220 may acquire a first profile related to the state of charge (SOC) of the battery. For example, the first profile may be acquired based on charging and discharging the battery. For example, the first profile may relate to the SOC of the battery acquired for a designated duration. For example, the processor 210 may acquire the first profile related to the SOC of the battery identified during a designated duration.

The processor 210 of the battery diagnosis device 200 according to an embodiment may acquire the first profile related to the SOC of the battery. For example, the processor 210 may apply a designated algorithm to the first profile related to the SOC of the battery. For example, the processor 210 may correct the first profile based on applying the designated algorithm to the first profile. For example, the processor 210 may acquire a second profile obtained by correcting the first profile based on applying the designated algorithm to the first profile. For example, the first profile and/or the second profile may be represented as a graph.

For example, the designated algorithm may include a local regression analysis algorithm. For example, the designated algorithm may include at least one of locally estimated scatterplot smoothing (LOESS), locally weighted scatterplot smoothing (LOWESS), locally weighted regression (LWR), or any combination thereof. For example, the designated algorithm may include an algorithm for flattening the profile and/or graph.

In an embodiment, the processor 210 may identify at least one first feature point in the second profile. For example, at least one of the first feature point may include an extremum point.

For example, the processor 210 may identify, based on identifying at least one first feature point in the second profile, at least one second feature point in the first profile using the at least one first feature point. For example, at least one second feature may include a local extremum point.

For example, the processor 210 may identify at least one second feature point using at least one first feature point by overlapping the first profile and the second profile.

For example, the processor 210 may identify at least one second feature point that exists between a plurality of feature points including at least one feature point. For example, the processor may identify at least one second feature point that exists between a first partial feature point and a second partial feature point among the plurality of feature points.

For example, the processor 210 may acquire an operating pattern of the battery based on identifying at least one second feature point. For example, the processor 210 may determine the operating pattern of the battery by connecting at least one second feature point. For example, the operating pattern may include at least one of a cycle mode, a FR mode, or any combination thereof.

In an embodiment, the processor 210 may acquire the operating pattern of the battery based on at least one second feature point. For example, the processor 210 may acquire the operating pattern of the battery based on a plurality of feature points including at least one second feature point. For example, the processor 210 may distinguish the operating pattern of the battery based on a trend line obtained by connecting a plurality of feature points including at least one second feature point.

In an embodiment, the processor 210 may predict the life of the battery based on the operating pattern of the battery.

As described above, the battery diagnosis device 200 according to an embodiment may acquire the operating pattern using the battery by using the first profile related to the SOC of the battery and the second profile obtained by correcting the first profile. The battery diagnosis device 200 may predict the life of the battery based on the operating pattern using the battery. The battery diagnosis device 200 may provide the effect of accurately predicting the life of the battery by predicting the life of the battery based on the operating pattern using the battery.

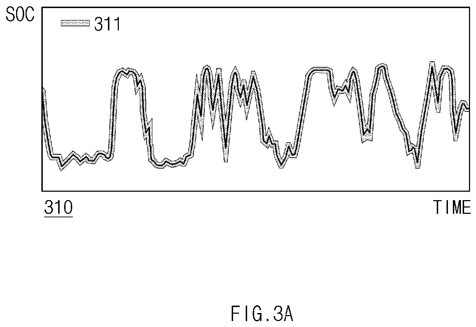

FIGS. 3a to 3e illustrate examples related to the first profile and/or the second profile in an embodiment of this document.

Referring to FIG. 3a, the processor 210 of the battery diagnosis device 200 according to an embodiment may acquire a first graph 320 related to a first profile. For example, in the first graph 310, a line 311 may represent the SOC of the battery.

For example, the horizontal axis of the first graph 310 may represent time. For example, the vertical axis of the first graph 310 may be the SOC of the battery.

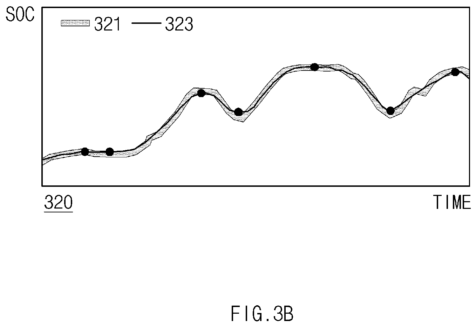

Referring to FIG. 3b, the processor 210 of the battery diagnosis device 200 according to an embodiment may acquire a second graph 320 by performing a designated algorithm on the first graph 310. For example, a line 321 shown in the second graph 320 may represent the SOC of the battery. For example, a line 323 shown in the second graph 320 may include result values obtained by performing a designated algorithm. For example, the second graph 320 may include overlapping graphs obtained by the first profile and the second profile.

For example, the horizontal axis of the second graph 320 may be time. For example, the vertical axis of the second graph 320 may be the SOC of the battery.

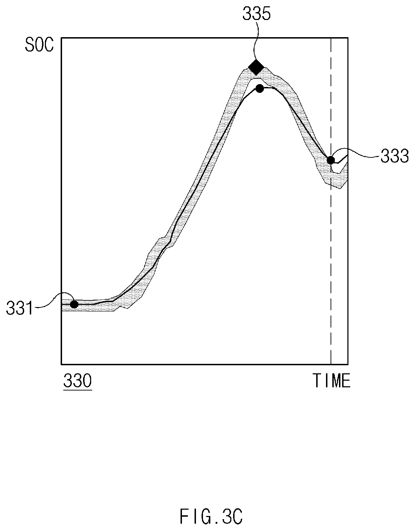

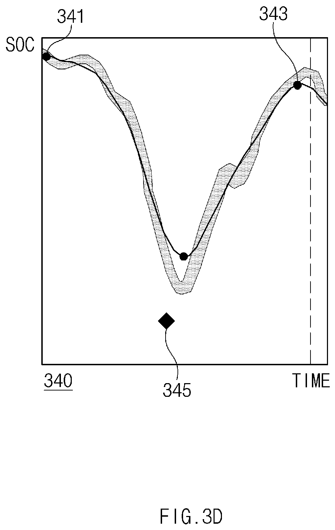

Referring to FIGS. 3c and 3d, the processor 210 of the battery diagnosis device 200 according to an embodiment may acquire a local extremum point.

Referring to FIG. 3c, the processor 210 of the battery diagnosis device 200 according to an embodiment may identify a first partial extremum point 331 in a third graph 330. For example, the processor 210 may identify a second partial extremum point 333 in the third graph 330. For example, the processor 210 may identify the first partial extremum point 331 and the second partial extremum point 333 in the third graph 330. For example, the third graph 330 may include at least a portion of the second graph 320. For example, the processor 210 may identify a first local extremum point 335 that exists between the first partial extremum point 331 and the second partial extremum point 333.

Referring to FIG. 3d, the processor 210 of the battery diagnosis device 200 according to an embodiment may identify a third partial extremum point 341 in a fourth graph 340. For example, the processor 210 may identify a fourth partial extremum point 343 in the fourth graph 340. For example, the processor 210 may identify the third partial extremum point 341 and the fourth partial extremum point 343 in the fourth graph 340. For example, the fourth graph 340 may include at least a portion of the second graph 320. For example, the processor 210 may identify a second local extremum point 345 that exists between the third partial extremum point 341 and the fourth partial extremum point 343.

For example, the first local extremum point 335 and/or the second local extremum point 345 may include local extremum points that exist in the first profile. For example, the first partial extremum point 331, the second partial extremum point 333, the third partial extremum point 341, and/or the fourth partial extremum point 343 may include extremum points that exist in the second profile.

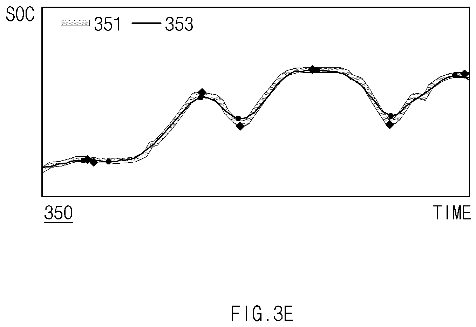

Referring to FIG. 3e, the processor 210 of the battery diagnosis device 200 according to an embodiment may acquire a fifth graph 350. For example, the processor 210 may acquire the fifth graph 350 based on the processes described in FIGS. 3A to 3D. For example, in the fifth graph 350, a line 351 may include the SOC of the battery. For example, in the fifth graph 350, a line 353 may include result values obtained by performing data processing on the SOC of the battery.

The processor 210 of the battery diagnosis device 200 according to an embodiment may identify the operation pattern of the battery based on the fifth graph 350. For example, the processor 210 of the battery diagnosis device 200 may predict the life of the battery based on identifying the operation pattern of the battery.

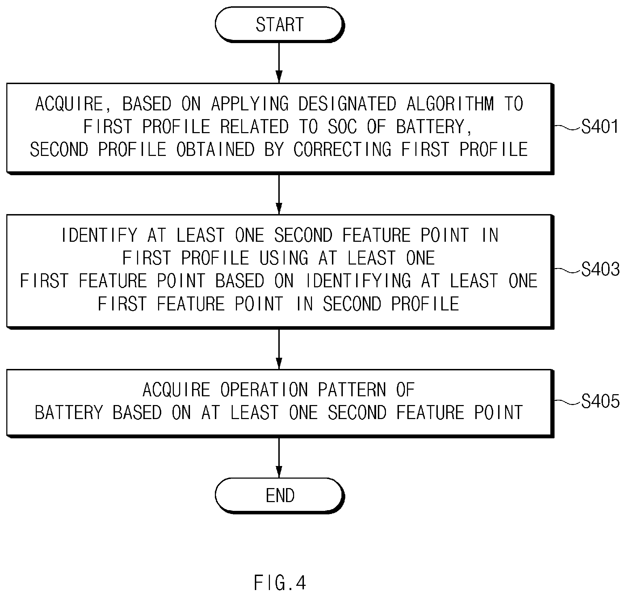

FIG. 4 illustrates an example of a flowchart related to a battery diagnosis method according to an embodiment of this document.

Hereinafter, it is assumed that the battery diagnosis device 200 of FIG. 2 performs the process of FIG. 4. In addition, in the description of FIG. 4, it may be understood that the operation described as being performed by the device is controlled by the processor 210 of the battery diagnosis device 200.

At least one of the operations of FIG. 4 may be performed by the battery diagnosis device 200 of FIG. 2. At least one of the operations of FIG. 4 may be controlled by the processor 210 of FIG. 2. Each of the operations of FIG. 4 may be performed sequentially, but they are not necessarily performed sequentially. For example, the order of each of the operations may be changed, and at least two operations may be performed in parallel.

Referring to FIG. 4, in operation S401, a battery diagnosis method according to an embodiment may include an operation of acquiring, based on applying a designated algorithm to a first profile related to the state of charge (SOC) of the battery, a second profile obtained by correcting the first profile.

For example, the battery diagnosis method may include an operation of acquiring the first profile based on the SOC of the battery identified for a designated duration. For example, the battery diagnosis method may include an operation of acquiring the first profile related to the SOC of the battery identified for the designated duration.

For example, the designated algorithm may include a local regression analysis algorithm. For example, the local regression analysis algorithm may include LOESS.

In operation S403, the battery diagnosis method according to an embodiment may include an operation of identifying at least one second feature point in the first profile using at least one first feature point based on identifying at least one first feature point in the second profile.

For example, the battery diagnosis method may include an operation of identifying the at least one second feature point that exists between a plurality of feature points including the at least one first feature point.

For example, at least one first feature point may include an extremum point. For example, at least one second feature point may include a local extremum point.

In operation S405, the battery diagnosis method according to an embodiment may include an operation of acquiring an operation pattern of the battery based on at least one second feature point.

For example, the operating pattern may include at least one of a cycle mode, an FR mode, or a combination thereof. However, examples of operating patterns are not limited to those described above.

For example, the battery diagnosis method may include an operation of predicting the life of the battery based on the operating pattern of the battery.

As described above, the battery diagnosis method according to an embodiment may include an operation of identifying the operating pattern using the battery using the first profile and the second profile. The battery diagnosis method may include an operation of predicting the life of the battery based on the operating pattern using the battery. The battery diagnosis method may provide the effect of accurately predicting the life of the battery by predicting the life of the battery based on the operating pattern using the battery.

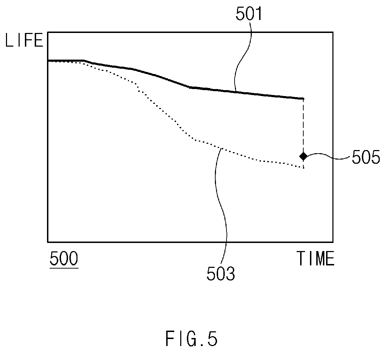

FIG. 5 illustrates an example of predicting the life of a battery using a battery diagnosis device and/or a battery diagnosis method according to an embodiment of this document.

Referring to FIG. 5, a graph 500 may represent a prediction of the life of the battery. For example, the horizontal axis of the graph 500 may represent time. For example, the vertical axis of the graph 500 may represent the life of the battery.

A line 501 shown in the graph 500 may represent the prediction of the life of the battery without applying the present technology.

A line 503 shown in the graph 500 may represent the prediction of the life of the battery by applying this technology.

A point 505 shown in the graph 500 may be the actual life of the battery.

As shown in the graph 500 of FIG. 5, it can be confirmed that the life of the battery is accurately predicted by applying the present technology.

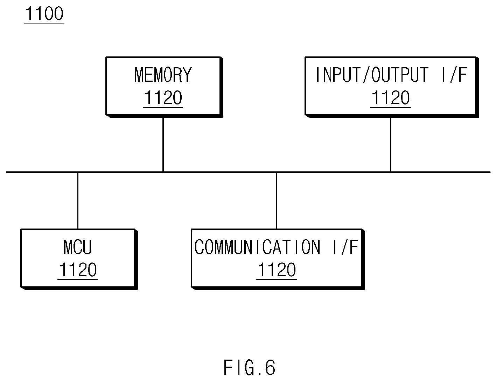

FIG. 6 is a block diagram illustrating a hardware configuration of a computing system that performs a battery diagnosis method, in a battery diagnosis device and battery diagnosis method according to an embodiment of this document.

Referring to FIG. 6, a computing system 1100 according to an embodiment disclosed in this document may include an MCU 1110, a memory 1120, an input/output I/F 1130, and a communication I/F 1140.

The MCU 1110 may be a processor that executes various programs (e.g., battery cell data collection program, graph generation program, data analysis program, data decomposition algorithm, normalization program, and battery cell diagnosis program, etc.) stored in the memory 1220, processes various information including characteristic data of the battery cell, latent variables, etc. through these programs, and performs the functions of the battery diagnosis device 200 shown in FIGS. 1 to 4 described above.

The memory 1120 may store various programs such as the battery cell data collection program, the graph generation program, the data analysis program, the data decomposition algorithm, the normalization program, and the battery cell diagnosis program.

A plurality of such memories 1120 may be provided as needed. The memory 1120 may be a volatile memory or a nonvolatile memory. The memory 1120 used as the volatile memory may be RAM, DRAM, SRAM, etc. The memory 1120 used as the nonvolatile memory may be ROM, PROM, EAROM, EPROM, EEPROM, flash memory, etc. The examples of the memories 1120 listed above are only examples, but are not limited to these examples.

The input/output I/F 1130 may provide an interface that allows data to be transmitted and received by connecting an input device (not shown) such as a keyboard, mouse, or touch panel and an output device such as a display (not shown) with the MCU 1110.

The communication I/F 1140 is a configuration that can transmit and receive various data with the server, and may be various devices that can support wired or wireless communication. For example, the battery diagnosis device 200 may transmit and receive various information including shape models of battery cells, etc. to and from a separately provided external server through the communication I/F 1140.

In this way, the computer program according to an embodiment disclosed in this document may be implemented as a module that performs, for example, each function shown in FIG. 2, by being recorded in the memory 1120 and processed by the MCU 1110.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

1. A battery diagnosis device, comprising:
an interface configured to acquire a first profile related to a state of charge (SOC) of a battery; and
a processor,
wherein the processor is configured to:
acquire a second profile obtained by correcting the first profile based on applying a designated algorithm to the first profile;
identify, based on identifying at least one first feature point in the second profile, at least one second feature point in the first profile using the at least one first feature point; and
acquire an operating pattern of the battery based on the at least one second feature point.

2. The battery diagnosis device of claim 1, wherein the processor is configured to predict the life of the battery based on the operating pattern of the battery.

3. The battery diagnosis device of claim 1, wherein the processor is configured to identify the at least one second feature point that exists between a plurality of feature points including the at least one first feature point.

4. The battery diagnosis device of claim 1, wherein the processor is configured to acquire the first profile related to the SOC of the battery identified for a designated duration.

5. The battery diagnosis device of claim 1, wherein the designated algorithm includes a local regression analysis algorithm.

6. The battery diagnosis device of claim 5, wherein the local regression analysis algorithm includes locally estimated scatterplot smoothing (LOESS).

7. The battery diagnosis device of claim 1, wherein the at least one first feature point includes an extremum point, and
the at least one second feature point includes a local extremum point.

8. The battery diagnosis device of claim 1, wherein the operating pattern includes at least one of a cycle mode, a FR mode, or any combination thereof.

9. A battery diagnosis method comprising:
an operation of acquiring, by a processor, based on applying a designated algorithm to a first profile related to a state of charge (SOC) of a battery, a second profile obtained by correcting the first profile;
an operation of identifying, by the processor, based on identifying at least one first feature point in the second profile, at least one second feature point in the first profile using the at least one first feature point; and
an operation of acquiring, by the processor, an operating pattern of the battery based on the at least one second feature point.

10. The battery diagnosis method of claim 9, wherein the battery diagnosis method comprises an operation of predicting the life of the battery based on the operating pattern of the battery.

11. The battery diagnosis method of claim 9, wherein the battery diagnosis method comprises an operation of identifying the at least one second feature point that exists between a plurality of feature points including the at least one first feature point.

12. The battery diagnosis method of claim 9, wherein the battery diagnosis method comprises an operation of acquiring the first profile related to the SOC of the battery identified for a designated duration.

13. The battery diagnosis method of claim 9, wherein the designated algorithm includes a local regression analysis algorithm.

14. The battery diagnosis method of claim 13, wherein the local regression analysis algorithm includes locally estimated scatterplot smoothing (LOESS).

15. The battery diagnosis method of claim 9, wherein the at least one first feature point includes an extremum point, and
the at least one second feature point includes a local extremum point.
